# EUROPEAN PATENT SPECIFICATION

(11) **EP 4 181 177 B1**
(45) Date of publication and mention of the grant of the patent: **18.03.2026**
(21) Application number: 22204387.9
(22) Date of filing: 28.10.2022
(51) Int. Cl.: H01L 21/48, H01L 23/495, H01L 23/00

(54) **METHOD OF MANUFACTURING SEMICONDUCTOR DEVICES AND CORRESPONDING SEMICONDUCTOR DEVICE**
VERFAHREN ZUR HERSTELLUNG VON HALBLEITERBAUELEMENTEN UND ZUGEHÖRIGES HALBLEITERBAUELEMENT
PROCÉDÉ DE FABRICATION DE DISPOSITIFS SEMI-CONDUCTEURS ET DISPOSITIF SEMI-CONDUCTEUR CORRESPONDANT

(30) Priority: 10.11.2021 IT 202100028553
(43) Date of publication of application: 17.05.2023
(73) Proprietor: STMicroelectronics S.r.l., 20864 Agrate Brianza (MB) (IT)
(72) Inventor: DERAI, Michele, 20149 Milano (IT); MAGNI, Pierangelo, 20852 Villasanta (Monza Brianza) (IT)
(74) Representative: Buzzi, Notaro & Antonielli d'Oulx S.p.A.

(56) References cited:
- US-A1- 2019 115 287

## Description

### Technical field

The description relates to semiconductor devices.

Semiconductor devices in Quad-Flat No-leads (QFN) packages may be exemplary of devices where embodiments can be advantageously applied.

### Background

Laser direct structuring or LDS technology (oftentimes referred to also as direct copper interconnect or DCI technology) has been recently proposed to replace conventional wire bonding in die-to-lead electrical connections in semiconductor devices.

In LDS technology as currently used today, after laser structuring (activation) in an LDS material, electrical conductivity of formations such as vias and lines or traces is facilitated via plating (e.g., electroless metallization followed by galvanic deposition) to reach a metallization thickness of tens of microns of metal material such as copper.

Document US 2019/115287 A1, taken as a model for the preambles of claims 1 and 9, discloses a method of manufacturing semiconductor devices such as integrated circuits that comprises providing one or more semiconductor chips having first and second opposed surfaces, coupling the semiconductor chip or chips with a support substrate with the second surface towards the support substrate, and embedding the semiconductor chip or chips coupled with the support substrate in electrically-insulating packaging material by providing in the packaging material electrically-conductive passageways. The electrically-conductive passageways comprise electrically-conductive chip passageways towards the first surface of the at least one semiconductor chip, and/or electrically-conductive substrate passageways towards the support substrate. In certain embodiments (e.g., the vias 24 of Fig. 14), these comprise a cylindrical portion extended by a tapered portion.

An issue arising when applying laser direct structuring in providing electrical connections in semiconductor devices such as QFN devices lies in the nearly 1:1 aspect ratio constraint related to the formation (e.g., electroplating) of frusto-conical vias.

The designation "aspect ratio" is currently adopted to denote the ratio of the width to the height of an image or an object in general.

Aspect ratio constraints in forming vias affect via landing on leads for fine pitch leadframes (0.4mm or less) or for packages where molding thickness is high (so-called "slug-up" QFNs, for instance) . An increase in via diameter can undesirably lead to undesired mis-alignment with respect to the leads and may result in metal short-circuits ("shorts").

### Object and summary

An object of one or more embodiments is to contribute in adequately dealing with such an aspect ratio issue.

According to one or more embodiments, such an object is achieved via a method having the features set forth in claim 1 that follows.

One or more embodiments relate to a corresponding semiconductor device as per claim 9.

Semiconductor devices in a Quad-Flat No-leads (QFN) package may be exemplary of devices where embodiments can be advantageously applied.

The claims are an integral part of the technical teaching provided herein in respect of the embodiments.

In solutions as disclosed herein the first (upper) end of the frusto-conical section has an area that is smaller than the cross-sectional area of the enlarged collar section at the intermediate plane of the encapsulation.

That facilitates adequately forming and filling through-mold vias, TMVs with a high aspect ratio. Moreover, it is noted that laser-drilling a conical portion in a via with a very marked taper is difficult to achieve while vertical or moderately tapered sidewalls are easier to manufacture/control.

One or more embodiments provide an approach in producing through mold vias (TMVs) that adequately addresses the aspect ratio issue discussed in the foregoing.

One or more embodiments improve manufacturability and package miniaturization.

For instance, embodiments as discussed herein improve manufacturability of fine-pitch Quad-Flat No-leads (QFN) packages using laser direct structuring (LDS) technology.

Examples as disclosed herein involve providing through mold vias comprising an upper collar, larger than a bottom via portion.

Examples as disclosed herein involve laser machining a through mold via in two ablation steps, to form first a collar recess and then a frusto-conical bottom via.

Examples as disclosed herein offer one or more of the following advantages:
the formation of a collar facilitates creating vias that are not constrained by a 1:1 aspect ratio, e.g., creating vias with a diameter smaller than mold cap (encapsulation) thickness;
a simpler molding process derives from the possibility of avoiding thin mold caps;
a simpler metallization process (e.g., Cu plating) can be implemented;
molding compound downsizing facilitates obtaining vias with a (global) aspect ratio no longer limited to 1:1 (that is, "lean" through mold vias can be produced having a height higher than their width); and
no additional process steps are involved over conventional package solutions based on LDS technology.

### Brief description of the figures

One or more embodiments will now be described, by way of example only, with reference to the annexed figures, wherein:
Figure 1 is a cross-sectional view through a semiconductor device exemplary of the possible application of LDS technology to manufacturing semiconductor devices,
Figure 2 is a cross-sectional view through a semiconductor device exemplary of manufacturing semiconductor devices according to embodiments of the present description,
Figure 3 is a plan view essentially along line III-III in Figure 2 further detailing manufacturing semiconductor devices according to embodiments of the present description, and
Figures 4A to 4H are exemplary of a possible sequence of steps in manufacturing semiconductor devices according to embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, various specific details are illustrated in order to provide an in-depth understanding of various examples of embodiments according to the description. The embodiments may be obtained without one or more of the specific details, or with other methods, components, materials, etc. In other cases, known structures, materials, or operations are not illustrated or described in detail so that various aspects of the embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment", "in one embodiment", or the like, that may be present in various points of the present description do not necessarily refer exactly to one and the same embodiment. Furthermore, particular configurations, structures, or characteristics may be combined in any adequate way in one or more embodiments.

The headings/references used herein are provided merely for convenience and hence do not define the extent of protection or the scope of the embodiments.

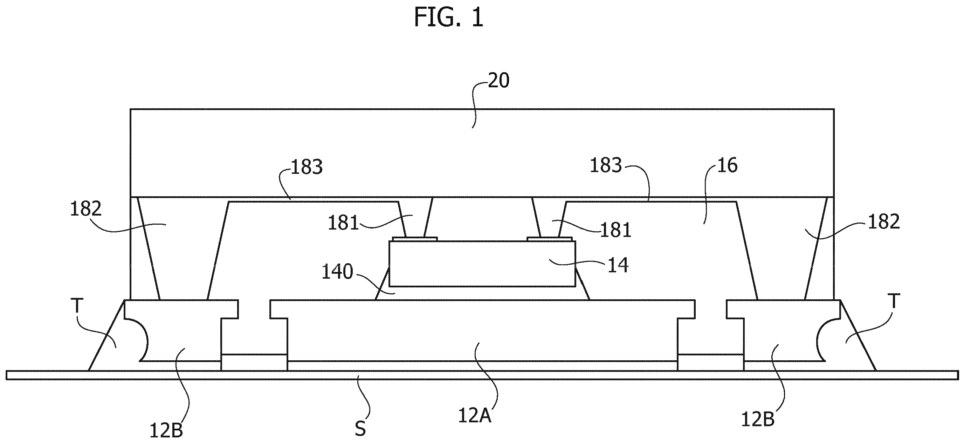

Figure 1 is representative of a possible application of laser direct structuring (LDS) technology in providing die-to-lead electrical coupling in a semiconductor device.

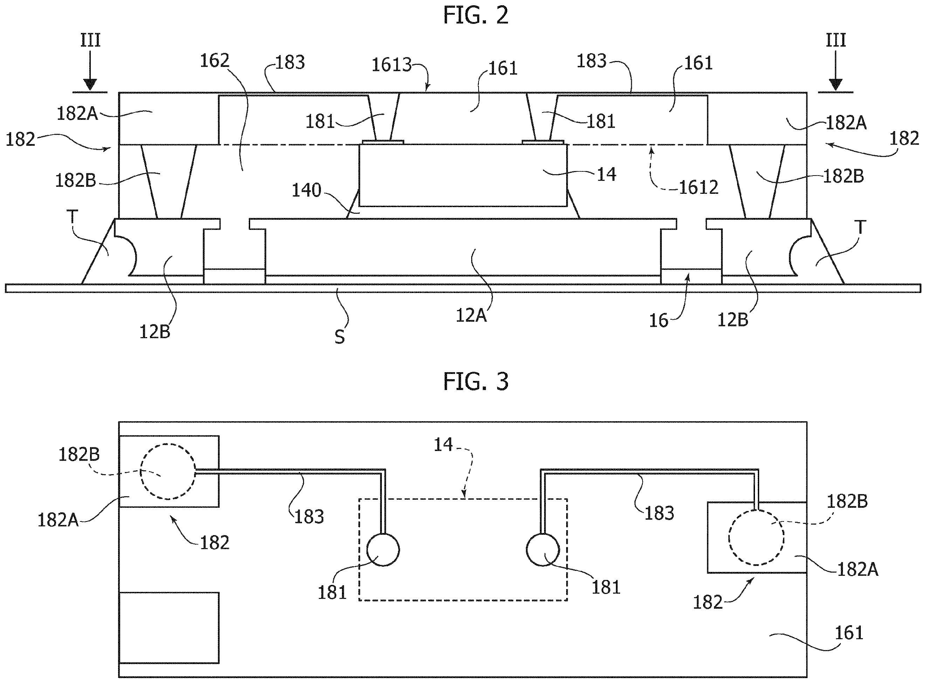

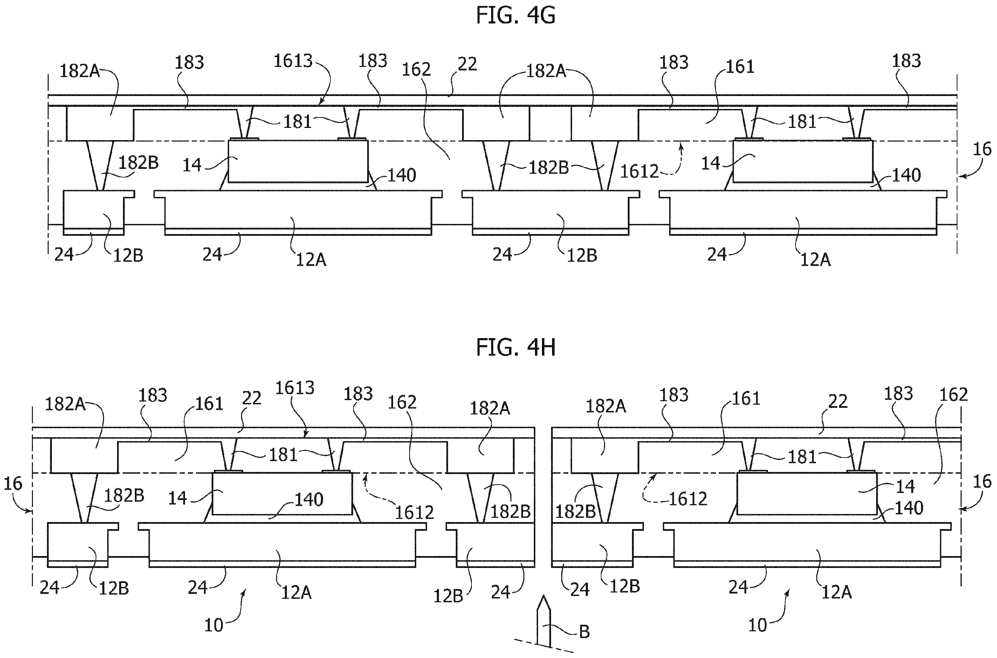

Figure 1 (and Figures 2 and 3 as well) refer for simplicity to a single device. In fact, devices as illustrated in these figures are currently manufactured in an assembly flow of plural semiconductor devices that are manufactured simultaneously and finally separated into individual devices 10 via a singulation step as exemplified in Figure 4H.

Figure 1 refers to a (single) device comprising a leadframe having one or more die pads 12A (only one is illustrated for simplicity) onto which respective semiconductor chips or dice 14 are mounted (for instance attached using die attach material 140) with an array of leads 12B around the die pad 12A and the semiconductor chips or dice 14.

As used herein, the terms chip/s and die/dice are regarded as synonymous.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the die or chip to other electrical components or contacts.

Essentially, a leadframe comprises an array of electrically-conductive formations (or leads, e.g., 12B) that from an outline location extend inwardly in the direction of a semiconductor chip or die (e.g., 14) thus forming an array of electrically-conductive formations from a die pad (e.g., 12A) configured to have at least one semiconductor chip or die attached thereon. This may be via conventional means such as a die attach adhesive (a die attach film or DAF, 140 for instance).

A device as illustrated in Figure 1 is intended to be mounted on a substrate S such as a printed circuit board (PCB), using solder material T, for instance.

For simplicity, in Figure 1 (and Figures 2 and 3 as well) a single die pad 12A is illustrated having a single chip 14 attached thereon. In various embodiments, plural chips 14 can be mounted on a single die pad 12A or plural die pads.

Laser direct structuring, LDS (oftentimes referred to also as direct copper interconnection or DCI technology) is a laser-based machining technique now widely used in various sectors of the industrial and consumer electronics markets, for instance for high-performance antenna integration, where an antenna design can be directly formed onto a molded plastic part. In an exemplary process, the molded parts can be produced with commercially available insulating resins that include additives suitable for the LDS process; a broad range of resins such as polymer resins like PC, PC/ABS, ABS, LCP are currently available for that purpose.

In LDS, a laser beam can be used to transfer ("structure") a desired electrically-conductive pattern onto a plastic molding that may then be subjected to metallization to finalize a desired conductive pattern.

Metallization may involve electroless plating followed by electrolytic plating.

Electroless plating, also known as chemical plating, is a class of industrial chemical processes that creates metal coatings on various materials by autocatalytic chemical reduction of metal cations in a liquid bath.

In electrolytic plating, an electric field between an anode and a workpiece, acting as a cathode, forces positively charged metal ions to move to the cathode where they give up their charge and deposit themselves as metal on the surface of the work piece.

Documents such as US 2018/342453 A1, US2019/115287 A1 (already cited), US 2020/203264 A1, US 2020/321274 A1, US 2021/050226 A1, US 2021/050299 A1, US 2021/183748 A1, or US 2021/305203 A1 (all assigned to the same assignee of the present application) are exemplary of the possibility of applying LDS technology in manufacturing semiconductor devices.

For instance, LDS technology facilitates replacing wires, clips or ribbons with lines/vias created by laser beam processing of an LDS material followed by metallization (growing metal such as copper via a plating process, for instance).

Still referring to Figure 1, an encapsulation 16 of LDS material can be molded onto the leadframe 12A, 12B having the semiconductor chip or die 14 mounted thereon.

Electrically conductive die-to-lead coupling formations can be provided (in a manner known per se: see the commonly assigned applications cited in the foregoing, for instance) in the LDS material 16 (once consolidated, e.g., via thermosetting).

As illustrated in Figure 1, these die-to-lead coupling formations comprise:
first vias 181 that extend through the LDS encapsulation 16 between the top (front) surface 16A of the LDS encapsulation 16 (opposed the leadframe 12A, 12B) and electrically-conductive pads (not visible for scale reasons) at the front or top surface of the chip or die 14,
second vias 182 that extend through the LDS encapsulation 16 between the top (front) surface 16A of the LDS encapsulation 16 and corresponding leads 12B in the leadframe, and
electrically-conductive lines or traces 183 that extend at the front or top surface 16A of the LDS encapsulation 16 and electrically couple selected ones of the first vias 181 with selected ones of the second vias 182 to provide a desired die-to-lead electrical connection pattern between the chip or die 14 and the leads 12B.

Providing the electrically conductive die-to-lead formations 181, 182, and 183 essentially involves structuring these formations in the LDS material 16, for instance, laser-drilling (blind) holes therein at the desired locations for the vias 181, 182, followed by growing electrically-conductive material (a metal such as copper, for instance) at the locations previously activated (structured) via laser beam energy.

As illustrated in Figure 1, further encapsulation material 20 (this can be non-LDS material, e.g., a standard epoxy resin) can be molded onto the die-to-lead formations 181, 182, and 183 to complete the device package.

Further details on processing as discussed in the foregoing can be derived from the commonly-assigned applications referred to in the foregoing, for instance.

Briefly, using LDS technology, through mold vias (TMVs) 181, 182 and traces 183 are created to electrically interconnect one or more semiconductor dice 14 to a leadframe (leads 12B) thereby replacing conventional wire bonding used for that purpose.

With LDS technology, the interconnection is created using laser structuring (to create vias and lines or traces) and metal plating is used to fill the laser-structured formations with metal such as copper.

Plating design rules allow only a nearly 1:1 aspect ratio (diameter v. depth) for through mold blind vias, in order to have a proper metal (e.g., copper) filling of the vias.

As illustrated in Figure 1, the (front or top) surface of the die 14 is usually at a higher level with respect to the leadframe (die pad 14A and leads 12B): as a consequence, the encapsulation 16 (molding compound layer) is thicker at the leadframe than at the die surface.

Being constrained to a nearly 1:1 aspect ratio, vias such as the vias 182 formed at the leads 12B may have proximal ends (opposite the leads 12B) that are undesirably large in comparison with the leads: for instance, these proximal ends (that is, the upper ends of the vias 182 in Figure 1) may have a diameter larger than the lead width.

Package design is adversely affected by this fact, primarily when a fine pitch (close spacing) is desired for the leads 12B.

For instance, assuming a 1:1 aspect ratio for vias design, the (larger) diameter of frusto-conical vias such as the vias 182 intended to connect to leads 12B can be chosen considering the thickness of the die attach material (140 in Figure 1) plus the thickness of the semiconductor chip (14 in Figure 1) and the (minimum) thickness of the LDS encapsulation 16 (for instance, about 30 microns should be preferably kept on top of die 14).

This may result in an undesired constraint in so far as only thin dice 14 (in a thickness range of 70 to 150 microns, assuming a die attach material thickness of 15 to 25 microns) can avoid the risk of having too large a vias (top) diameter, with possible "fall out" of the vias from the leads (having a width of 200 to 300 microns).

In conventional arrangements as illustrated in Figure 1, increasing the thickness of the LDS encapsulation 16 may result in a larger vias diameter with possible via-to-lead mismatches: vias with diameter dimensions close to the lead width will leave only a poor margin to keep vias within the leads without "going out" of the leads.

Italian patent applications 102021000020537 and 102021000020540 (both assigned to the same assignee of the present application and not yet available to the public at the time of filing of the present application) disclose the possibility of extending the use of LDS processing from producing die-to-lead coupling formations as discussed in the foregoing to producing die-to-die coupling formations.

Issues similar to the issues discussed in the foregoing in connection with forming vias in die-to-lead coupling formations may thus arise when forming vias in die-to-die coupling formations.

While disclosed for simplicity in connection with forming vias in die-to-lead coupling formations, the examples herein can be advantageously applied to forming vias in die-to-die coupling formations. Similarly, these examples can be advantageously applied to vias in metallization-to-metallization level coupling formations as discussed in US 2021/183748 A1 (already cited) .

Consequently, the embodiments herein shall not be regarded as limited to forming vias in die-to-lead coupling formations.

Throughout Figures 2, 3 and 4A to 4H parts or elements like parts or elements already discussed in connection with Figure 1 are indicated with like reference symbols. A corresponding detailed description of these parts or elements and the way they can be produced will not be repeated for brevity.

In the examples to which Figures 2, 3 and 4A to 4H refer, through mold vias (TMVs) such as the vias 182 include two sections 182A and 182B formed in two superposed portions or layers 161 and 162 of the LDS encapsulation material 16.

In the examples to which Figures 2, 3 and 4A to 4H refer, a first section or portion of the vias 182 comprises an enlarged collar portion 182A formed into and through the first (outer) portion or layer 161 of the encapsulation of LDS material 16.

The first (outer) portion or layer 161 of the LDS material 16 is molded "on top" of the second (inner) portion or layer 162.

The first (outer) portion 161 thus extends from a (notional) intermediate plane 1612 of the LDS encapsulation 16 up to a front or top surface 1613 of the (whole) LDS encapsulation 16.

A second section or portion 182B of the vias 182 comprises an (otherwise conventional) frusto-conical via formed through the second (inner) portion or layer 162 of the encapsulation of LDS material 16 that extends from the intermediate plane 1612 of the LDS encapsulation 16 towards the leadframe 12A, 12B.

The second portion 162 of the LDS encapsulation 16 is thus adjacent to the substrate 12A, 12B and borders on the first portion 161 at the intermediate plane 1612 of the encapsulation.

Like in the case of Figure 1, in examples as presented in Figures 2 and 3, the vias 181 can be formed (in a manner known to those of skill in the art) through the first portion or layer 161 of the encapsulation of LDS material 16 molded onto the second portion or layer 162.

The vias 181 thus extend from the front or top surface 1613 of the (whole) LDS encapsulation to die pads (not visible for reasons of scale) at the front or top surface of the die 14.

As illustrated, the front or top surface of the die 14 lies (at least approximately) at or in the vicinity of the intermediate plane 1612. As used herein, the expression "approximately" refers to a technical feature within the technical tolerance of the method used to manufacture and/or measure it.

Electrically conductive lines or traces 183 can be formed (in a manner likewise known to those of skill in the art) at the front or top surface 1613 of the (whole) LDS encapsulation 16 to electrically couple the vias 181 to (the collars 182A of) the vias 182.

Examples as presented in Figures 2 and 3 use the collar 182A to reduce to the (sole) thickness of the second layer 162 the thickness of the LDS molding compound 16 through which the frusto-conical sections 182B of the vias 182 are formed.

The collars 182A formed in the first portion or layer 161 of the encapsulation 16 can be larger than the (larger diameter of the) vias 182B formed in the second portion or layer 162 of the encapsulation 16.

The size and dimensions of the collars 182A are largely independent of the sizes of the leads 12B. Collar dimensions can be (much) larger than the diameter of the frusto-conical vias 182B (ad measured in the plane 1612).

As visible, e.g., in Figure 3, the collars 182A can be formed as parallelepiped notches "carved out" (by laser ablation, for instance) in the encapsulation layer 161.

This (also) facilitates plating metal (e.g.., Cu) flow into the collars 182A to reach (and fill) the frusto-conical via portions 182B.

Vias 182 with a collar 182A may show (as a whole) a lean "cylindrical" shape (in contrast to the general frusto-conical shape of conventional vias 182 as illustrated in Figure 1).

This facilitates achieving a larger bottom diameter of the vias 182 (at the leads 12B) while avoiding the limitations related to a 1:1 aspect ratio.

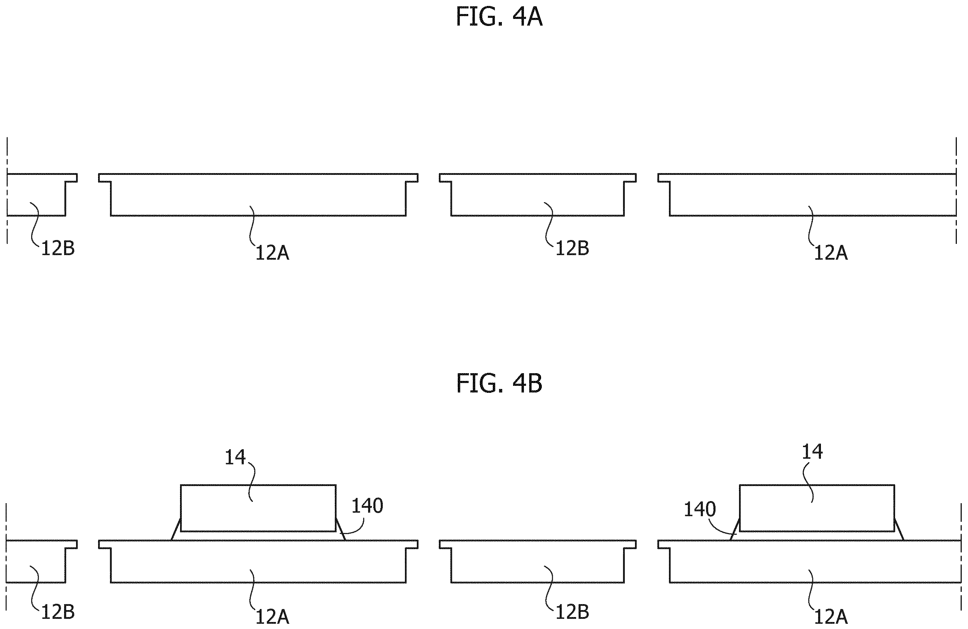

Figures 4A to 4H are exemplary of a possible sequence of steps in manufacturing semiconductor devices 10 based on the criteria discussed in connection with Figures 2 and 3.

Such a sequence involves laser machining a through mold via in two ablation steps, to form first a collar recess (e.g., a collar section 182A) and then a frusto-conical bottom via (e.g., a frusto-conical section 182B), that is forming first the enlarged collar section 182A and then forming the frusto-conical section 182B subsequent to forming the enlarged collar section 182A.

It will be otherwise appreciated that the sequence of Figures 4A to 4H is merely exemplary in so far as:
one or more steps illustrated can be omitted, performed in a different manner (with other tools, for instance) and/or replaced by other steps;
additional steps and may be added;
one or more steps can be carried out in a sequence different from the sequence illustrated.

Also, unless the context indicates differently, the individual steps illustrated in Figures 4A to 4H can be performed in a manner known to those of skill in the art, which makes it unnecessary to provide a more detailed description of these individual steps.

The sequence of steps of Figures 4A to 4H refers to the current practice of manufacturing semiconductor devices in an assembly flow of plural semiconductor devices that are manufactured simultaneously and finally separated into individual devices 10 via a singulation step (as exemplified in Figure 4H).

Figure 4A is exemplary of the provision of a (standard, e.g., metal) leadframe including die pads 12A as well as lead portions intended to provide arrays of leads 12B around the die pads 12A.

In that respect it is noted that the designation Quad-Flat No-leads (QFN) designation currently applied to devices such as the devices 10 illustrated herein refers primarily to the fact that, while including leads such as the leads 12B, these devices have no leads protruding radially from the package.

Figure 4B is exemplary of semiconductor chips or dice 14 being attached at the die pads 12A. This may occur, as conventional in the art, via die attach material 140.

As noted, plural semiconductor chips or dice 14 can be arranged at the (front or top) surface of each die pad 12A: one chip or die 14 is illustrated here for simplicity.

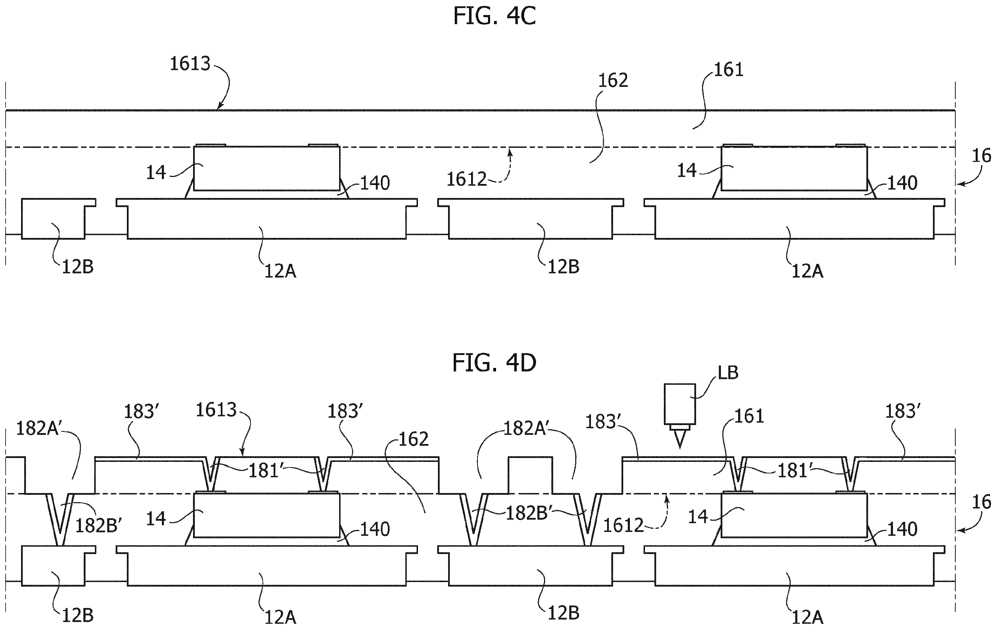

Figure 4C is exemplary of an encapsulation 16 of laser direct structuring (LDS) material being molded onto the structure of Figure 4B.

The step of Figure 4C can be implemented in a manner known per se (e.g., via compression molding of LDS molding compound including additives making it suited for laser activation as conventional in LDS processing).

Figure 4C is thus exemplary of encapsulating the substrate (leadframe) 12A, 12B with the semiconductor chip 14 arranged thereon in an encapsulation 16 of laser direct structuring (LDS) material.

While in most instances applied as a single mass of LDS material, the encapsulation 16 can be regarded as comprising:
an inner portion or layer (designated 162) having the chips or dice 14 embedded therein and extending up to the (notional) plane 1612 essentially flush with the front or top surface of the chips or dice 14, and
an outer portion or layer (designated 161) molded "on top" of the inner layer 162 (and the chips or dice 14), with the outer portion or layer 161 extending from the plane 1612 to the front or top surface 1613 of the (whole) LDS encapsulation 16.

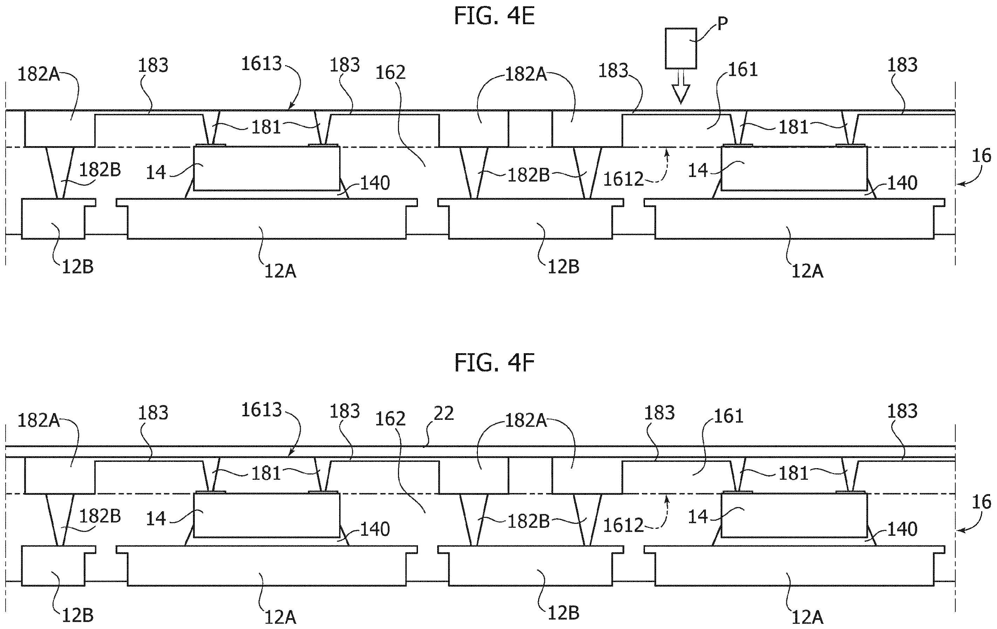

Figures 4D and 4E are exemplary of the application of laser beam energy LB to selected areas of the LDS material of the encapsulation 16 (Figure 4D) followed by metallization P (e.g., electroless and electrolytic growth of conductive material such as copper - Figure 4E) to form:
the first vias 181 extending through the first layer 161 of the LDS encapsulation 16 between electrically-conductive pads (not visible for scale reasons) provided at the front or top surface of the chips or dice 14 (essentially lying in the plane 1612) and the top (front) surface 1613 of the whole encapsulation (opposed the leadframe 12A, 12B),
the second vias 182A, 182B (182 as a whole) extending through the LDS encapsulation 16 between the top (front) surface 1613 of the LDS encapsulation 16 and corresponding leads 12B in the leadframe, passing through the (notional) plane 1612, and
electrically-conductive lines or traces 183 extending at the front or top surface 1613 of the LDS encapsulation 16 and electrically coupling selected ones of the first vias 181 with selected ones of the second vias 182 (collar portion 182A) to provide a desired die-to-lead electrical connection pattern between the chips or dice 14 and the leads 12B.

In Figure 4D, reference numbers with hyphens (namely 181', 182A', 182B' and 183') are used to designate the result of applying laser beam energy (as exemplified by reference LB 4D) to the LDS encapsulation material 16.

In Figure 4E, reference corresponding numbers without hyphens (namely 181, 182A, 182B and 183) are used to designate the result of a metallization step (as exemplified by reference P in Figure 4E) of the locations 181', 182A', 182B' and 183' that facilitates electrical conductivity of the vias 181, 182 and the lines or traces 183.

As illustrated, applying LDS processing to the encapsulation 16 of LDS material comprises:
applying laser beam energy LB to the LDS material 16 to provide therein laser-ablated regions for the collars 182A' as well as for the vias 181', 182B' and the lines or traces 183', and
growing (via plating P, for instance) electrically conductive material at the laser-activated/ablated regions 181', 182A', 182B' and 183'.

As illustrated in Figures 4D and 4E, providing the vias 182 comprises providing the two parts or portions thereof - namely the collar section 182A and the frusto-conical section 182B - formed in the two superposed layers 161 and 162 of the LDS encapsulation 16.

In terms of process flow, cavities for the collar sections 182A' can be formed first - via laser ablation, for instance - through the outer layer 161 of the encapsulation of LDS material molded "on top" of the inner layer 162.

A frusto-conical section can then be formed (e.g., laser-drilled as 182B') at the bottom of the collar section 182A', with the frusto-conical section 182B' extending through the inner layer 162 of the encapsulation 16 of LDS material from the notional plane 1612 (essentially flush with the front or top surface of the chip or die 14) to a respective lead 12B.

Metal material (e.g., copper) can then be grown into the sections 182A' and 182B' to facilitate electrical conductivity of the via 182 (collar 182A plus the frusto-conical via 182B) extending through the mold material 16 (layers 161 and 162) from the front or top surface 1613 of the (whole) LDS encapsulation 16 to the leads 12B passing through the (notional) intermediate plane 1612.

Figures 4D and 4E are thus exemplary of providing an electrical bonding pattern (vias 181, 182A, 182B plus lines or traces 183) between the semiconductor chip or chips 14 and selected ones of the leads 12B in the array of electrically conductive leads.

Figure 4F is exemplary of the deposition of a passivation layer 22 at the front or top surface 1613 of the encapsulation 16. Passive components (not visible for simplicity) can be placed on the metallized lines or traces 183 at this stage.

Figure 4G is exemplary of tin plating 24 applied at the back or bottom surface to facilitate mounting onto a substrate (see S in Figure 2), e.g., via soldering material T.

Figure 4H is exemplary of singulation (e.g., via a rotary blade B) to provide individual semiconductor devices 10.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
arranging on a substrate (12A, 12B) at least one semiconductor die (14),
molding an encapsulation of laser direct structuring, LDS material (16; 161, 162) onto the at least one semiconductor die (14) arranged on the substrate (12A, 12B), the encapsulation (16) having an outer surface (1613) opposite the substrate (12A, 12B) and comprising a first portion (161) of the encapsulation (16) between the outer surface (1613) and an intermediate plane (1612) of the encapsulation (16) as well as a second portion (162) of the encapsulation (16) adjacent to the substrate (12A, 12B) and bordering on the first portion (161) of the encapsulation (16) at said intermediate plane (1612), and
providing at least one electrically conductive via (182) extending through the encapsulation of LDS material (16; 161, 162), wherein the at least one electrically conductive via (182) comprises:
an enlarged collar section (182A) extending through the first portion (161) of the encapsulation (16) from the outer surface (1613) to the intermediate plane (1612) of the encapsulation (16), the enlarged collar section (182A) having a cross-sectional area at the intermediate plane (1612) of the encapsulation (16), and
a frusto-conical section (182B) extending through the second portion (162) of the encapsulation (16; 161, 162) from a first end having a first diameter at the intermediate plane (1612) of the encapsulation (16; 161, 162) to a second end having a second diameter away from the intermediate plane (1612) of the encapsulation (16; 161, 162), wherein the second diameter of the frusto-conical section (182B) is smaller than the first diameter of the frusto-conical section (182B),
**characterized in that** the first end of the frusto-conical section (182B) has an area smaller than the cross-sectional area of the enlarged collar section (182A) at the intermediate plane (1612) of the encapsulation (16).

2. The method of claim 1, comprising providing the at least one electrically conductive via (182) extending through the encapsulation of LDS material (16; 161, 162), by forming the enlarged collar section (182A) and then forming the frusto-conical section (182B) subsequent to forming the enlarged collar section (182A).

3. The method of claim 1 or claim 2, wherein the frusto-conical section (182B) of the at least one electrically conductive via (182) has an aspect ratio approximately equal to 1:1.

4. The method of any of claims 1 to 3, comprising arranging on the substrate (12A, 12B) at least one semiconductor die (14) having a front surface opposite to the substrate (12A, 12B) wherein the front surface of the at least one semiconductor die (14) lies at least approximately at the intermediate plane (1612) of the encapsulation (16; 161, 162) of LDS material (16; 161, 162) molded onto the at least one semiconductor die (14) arranged on the substrate (12A, 12B).

5. The method of any of the previous claims, wherein the at least one semiconductor die (14) is arranged at a die pad (12A) of a leadframe comprising an array of electrically conductive leads (12B) around the die pad (12A), wherein the method comprises providing said at least one electrically conductive via (182) extending through the first (161) and second (162) portions of the encapsulation (16; 161, 162) of LDS material from the outer surface (1613) of the encapsulation (16; 162, 162) to at least one lead in the array of electrically conductive leads (12B) around the die pad (12A).

6. The method of claim 4 and claim 5, wherein the method comprises forming:
at least one frusto-conical, electrically conductive via (181) extending through the first portion (161) of the encapsulation (16; 161, 162) of LDS material from the outer surface (1613) of the encapsulation (16; 161, 162) to a front surface of the at least one semiconductor die (14), and
at least one linear, electrically conductive formation (183) extending at the outer surface (1613) of the encapsulation (16; 161, 162) of LDS material and coupling said at least one frusto-conical, electrically conductive via (181) and the enlarged collar section (182A) of the at least one electrically conductive via (182) to provide electrical coupling of the at least one semiconductor die (14) with the at least one lead in the array of electrically conductive leads (12B) around the die pad (12A).

7. The method of any of the previous claims, comprising:
applying laser beam energy (LB) to at least one selected location (181', 182A', 182B'; 183') of the encapsulation (16; 161, 162) of LDS material, and
growing (P) metal material, preferably copper, onto said at least one selected location (181', 182A', 182B'; 183') of the encapsulation (16; 161, 162) of LDS material to which laser beam energy (LB) has been applied.

8. The method of claim 7, wherein said growing metal material (P) comprises:
electroless growing metal material onto said at least one selected location (181', 182A', 182B'; 183') of the encapsulation (16; 161, 162) of LDS material to which laser beam energy (LB) has been applied, and
electrolytic growing metal material onto the metal material electroless grown onto said at least one selected location (181', 182A', 182B'; 183') to which laser beam energy (LB) has been applied.

9. A device (10), comprising:
at least one semiconductor die (14) arranged on a substrate (12A, 12B),
an encapsulation of laser direct structuring, LDS material (16; 161, 162) molded onto the at least one semiconductor die (14) arranged on the substrate (12A, 12B), the encapsulation (16) having an outer surface (1613) opposite the substrate (12A, 12B) and comprising a first portion (161) of the encapsulation (16) between the outer surface (1613) and an intermediate plane (1612) of the encapsulation (16) as well as a second portion (162) of the encapsulation (16) adjacent to the substrate (12A, 12B) and bordering on the first portion (161) of the encapsulation (16) at said intermediate plane (1612), and
at least one electrically conductive via (182) extending through the encapsulation of LDS material (16; 161, 162), wherein the at least one electrically conductive via (182) comprises:
an enlarged collar section (182A) extending through the first portion (161) of the encapsulation (16) from the outer surface (1613) to the intermediate plane (1612) of the encapsulation (16), the enlarged collar section (182A) having a cross-sectional area at the intermediate plane (1612) of the encapsulation (16), and
a frusto-conical section (182B) extending through the second portion (162) of the encapsulation (16; 161, 162), wherein the frusto-conical section (182B) has a first end with a first diameter at the intermediate plane (1612) of the encapsulation (16; 161, 162) and a second end with a second diameter away from the intermediate plane (1612) of the encapsulation (16; 161, 162), wherein the second diameter of the frusto-conical section (182B) is smaller than the first diameter of the frusto-conical section (182B),
**characterized in that** the first end of the frusto-conical section (182B) has an area smaller than the cross-sectional area of the enlarged collar section (182A) at the intermediate plane (1612) of the encapsulation (16).

10. The device (10) of claim 9, wherein the frusto-conical section (182B) of the at least one electrically conductive via (182) has an aspect ratio approximately equal to 1:1.

11. The device (10) of claim 9 or claim 10, wherein the at least one semiconductor die (14) has a front surface opposite to the substrate (12A, 12B) wherein the front surface of the at least one semiconductor die (14) lies at least approximately at the intermediate plane (1612) of the encapsulation (16; 161, 162) of LDS material (16; 161, 162) molded onto the at least one semiconductor die (14) arranged on the substrate (12A, 12B).

12. The device (10) of any of claims 9 to 11, wherein the at least one semiconductor die (14) is arranged at a die pad (12A) of a leadframe comprising an array of electrically conductive leads (12B) around the die pad (12A), wherein the at least one electrically conductive via (182) extends through the first (161) and second (162) portions of the encapsulation (16; 161, 162) of LDS material from the outer surface (1613) of the encapsulation (16; 162, 162) to at least one lead in the array of electrically conductive leads (12B) around the die pad (12A).

13. The device (10) of claims 11 and 12, comprising:
at least one frusto-conical, electrically conductive via (181) extending through the first portion (161) of the encapsulation (16; 161, 162) of LDS material from the outer surface (1613) of the encapsulation (16; 161, 162) to a front surface of the at least one semiconductor die (14), and
at least one linear, electrically conductive formation (183) extending at the outer surface (1613) of the encapsulation (16; 161, 162) of LDS material and coupling said at least one frusto-conical, electrically conductive via (181) and the enlarged collar section (182A) of the at least one electrically conductive via (182) to provide electrical coupling of the at least one semiconductor die (14) with the at least one lead in the array of electrically conductive leads (12B) around the die pad (12A).

14. The device (10) of any of claims 9 to 13, comprising:
at least one laser-ablated, selected location (181', 182A', 182B'; 183') of the encapsulation (16; 161, 162) of LDS material, and
metal material, preferably copper, grown onto said at least one laser-ablated selected location (181', 182A', 182B'; 183') of the encapsulation (16; 161, 162) of LDS material.

15. The device (10) of claim 14, wherein the metal material grown onto said at least one laser-ablated selected location (181', 182A', 182B'; 183') of the encapsulation (16; 161, 162) of LDS material comprises:
metal material electroless grown onto said at least one laser-ablated selected location (181', 182A', 182B'; 183') of the encapsulation (16; 161, 162), and
metal material electrolytically growing onto the metal material electroless grown onto said at least one laser-ablated selected location (181', 182A', 182B'; 183') of the encapsulation (16; 161, 162).

## Patentansprüche

1. Verfahren, umfassend:
Anordnen mindestens eines Halbleiterchips (14) auf einem Substrat (12A, 12B),
Formen einer Einkapselung aus Laserdirektstrukturierungs, LDS,-Material (16; 161, 162) auf den mindestens einen auf dem Substrat (12A, 12B) angeordneten Halbleiterchip (14), wobei die Einkapselung (16) eine dem Substrat (12A, 12B) gegenüberliegende Außenfläche (1613) aufweist und einen ersten Abschnitt (161) der Einkapselung (16) zwischen der Außenfläche (1613) und einer Zwischenebene (1612) der Einkapselung (16) sowie einen zweiten Abschnitt (162) der Einkapselung (16) benachbart zu dem Substrat (12A, 12B) und angrenzend an den ersten Abschnitt (161) der Einkapselung (16) an der Zwischenebene (1612) umfasst, und Bereitstellen mindestens einer elektrisch leitfähigen Durchkontaktierung (182), die sich durch die Einkapselung von LDS-Material (16; 161, 162) erstreckt, wobei die mindestens eine elektrisch leitfähige Durchkontaktierung (182) Folgendes umfasst:
einen vergrößerten Kragenabschnitt (182A), der sich durch den ersten Abschnitt (161) der Einkapselung (16) von der Außenfläche (1613) bis zur Zwischenebene (1612) der Einkapselung (16) erstreckt, wobei der vergrößerte Kragenabschnitt (182A) einen Querschnittsbereich an der Zwischenebene (1612) der Einkapselung (16) aufweist, und
einen kegelstumpfförmigen Abschnitt (182B), der sich durch den zweiten Abschnitt (162) der Einkapselung (16; 161, 162) von einem ersten Ende mit einem ersten Durchmesser an der Zwischenebene (1612) der Einkapselung (16; 161, 162) zu einem zweiten Ende mit einem zweiten Durchmesser entfernt von der Zwischenebene (1612) der Einkapselung (16; 161, 162) erstreckt, wobei der zweite Durchmesser des kegelstumpfförmigen Abschnitts (182B) kleiner ist als der erste Durchmesser des kegelstumpfförmigen Abschnitts (182B),
**dadurch gekennzeichnet, dass** das erste Ende des kegelstumpfförmigen Abschnitts (182B) eine Fläche aufweist, die kleiner ist als die Querschnittsfläche des vergrößerten Kragenabschnitts (182A) an der Zwischenebene (1612) der Einkapselung (16).

2. Verfahren nach Anspruch 1, umfassend das Bereitstellen der mindestens einen elektrisch leitfähigen Durchkontaktierung (182), die sich durch die Einkapselung aus LDS-Material (16; 161, 162) erstreckt, indem der vergrößerte Kragenabschnitt (182A) gebildet wird und dann der kegelstumpfförmige Abschnitt (182B) gebildet wird, nachdem der vergrößerte Kragenabschnitt (182A) gebildet wurde.

3. Verfahren nach Anspruch 1 oder Anspruch 2, wobei der kegelstumpfförmige Abschnitt (182B) der mindestens einen elektrisch leitfähigen Durchkontaktierung (182) ein Seitenverhältnis von etwa gleich 1:1 aufweist.

4. Verfahren nach einem der Ansprüche 1 bis 3, umfassend das Anordnen mindestens eines Halbleiterchips (14) mit einer dem Substrat (12A, 12B) gegenüberliegenden Vorderfläche auf dem Substrat (12A, 12B), wobei die Vorderfläche des mindestens einen Halbleiterchips (14) mindestens etwa auf der Zwischenebene (1612) der Einkapselung (16; 161, 162) aus LDS-Material (16; 161, 162) liegt, die auf den mindestens einen auf dem Substrat (12A, 12B) angeordneten Halbleiterchip (14) geformt ist.

5. Verfahren nach einem der vorhergehenden Ansprüche, wobei der mindestens eine Halbleiterchip (14) an einer Chipkontaktstelle (12A) eines Leiterrahmens angeordnet ist, der ein Array elektrisch leitfähiger Leitungen (12B) um die Chipkontaktstelle (12A) herum umfasst, wobei das Verfahren das Bereitstellen der mindestens einen elektrisch leitfähigen Durchkontaktierung (182) umfasst, die sich durch den ersten (161) und den zweiten (162) Abschnitt der Einkapselung (16; 161, 162) aus LDS-Material von der Außenfläche (1613) der Einkapselung (16; 162, 162) zu mindestens einer Leitung in dem Array elektrisch leitfähiger Leitungen (12B) um die Chipkontaktstelle (12A) herum erstreckt.

6. Verfahren nach Anspruch 4 und Anspruch 5, wobei das Verfahren das Formen von Folgendem umfasst:
mindestens einer kegelstumpfförmigen, elektrisch leitfähigen Durchkontaktierung (181), die sich durch den ersten Abschnitt (161) der Einkapselung (16; 161, 162) aus LDS-Material von der Außenfläche (1613) der Einkapselung (16; 161, 162) zu einer Vorderfläche des mindestens einen Halbleiterchips (14) erstreckt, und
mindestens eine lineare, elektrisch leitfähige Formation (183), die sich an der Außenfläche (1613) der Einkapselung (16; 161, 162) aus LDS-Material erstreckt und die mindestens eine kegelstumpfförmige, elektrisch leitfähige Durchkontaktierung (181) und den vergrößerten Kragenabschnitt (182A) der mindestens einen elektrisch leitfähigen Durchkontaktierung (182) koppelt, um die elektrische Kopplung des mindestens einen Halbleiterchips (14) mit der mindestens einen Leitung in dem Array elektrisch leitfähiger Leitungen (12B) um die Chipkontaktstelle (12A) herum bereitzustellen.

7. Verfahren nach einem der vorstehenden Ansprüche, das Folgendes umfasst:
Anwenden von Laserstrahlenergie (LB) auf mindestens eine ausgewählte Stelle (181', 182A', 182B'; 183') der Einkapselung (16; 161, 162) aus LDS-Material, und
Aufwachsen (P) von Metallmaterial, vorzugsweise Kupfer, auf die mindestens eine ausgewählte Stelle (181', 182A', 182B'; 183') der Einkapselung (16; 161, 162) aus LDS-Material, auf die Laserstrahlenergie (LB) angewendet wurde.

8. Verfahren nach Anspruch 7, wobei das Aufwachsen von Metallmaterial (P) Folgendes umfasst:
stromloses Aufwachsen von Metallmaterial auf die mindestens eine ausgewählte Stelle (181', 182A', 182B'; 183') der Einkapselung (16; 161, 162) aus LDS-Material, auf die Laserstrahlenergie (LB) angewendet wurde, und elektrolytisch Aufwachsen von Metallmaterial auf das Metallmaterial, das stromlos auf die mindestens eine ausgewählte Stelle (181', 182A', 182B'; 183') aufgewachsen ist, auf die Laserstrahlenergie (LB) angewendet wurde.

9. Vorrichtung (10), die Folgendes umfasst:
mindestens einen auf einem Substrat (12A, 12B) angeordneten Halbleiterchip (14),
eine Einkapselung aus Laserdirektstrukturierungs, LDS,-Material (16; 161, 162), die auf den mindestens einen auf dem Substrat (12A, 12B) angeordneten Halbleiterchip (14) geformt ist, wobei die Einkapselung (16) eine dem Substrat (12A, 12B) gegenüberliegende Außenfläche (1613) aufweist und einen ersten Abschnitt (161) der Einkapselung (16) zwischen der Außenfläche (1613) und einer Zwischenebene (1612) der Einkapselung (16) sowie einen zweiten Abschnitt (162) der Einkapselung (16) benachbart zu dem Substrat (12A, 12B) und angrenzend an den ersten Abschnitt (161) der Einkapselung (16) an der Zwischenebene (1612) umfasst, und
mindestens eine elektrisch leitfähige Durchkontaktierung (182), die sich durch die Einkapselung von LDS-Material (16; 161, 162) erstreckt, wobei die mindestens eine elektrisch leitfähige Durchkontaktierung (182) Folgendes umfasst:
einen vergrößerten Kragenabschnitt (182A), der sich durch den ersten Abschnitt (161) der Einkapselung (16) von der Außenfläche (1613) bis zur Zwischenebene (1612) der Einkapselung (16) erstreckt, wobei der vergrößerte Kragenabschnitt (182A) einen Querschnittsbereich an der Zwischenebene (1612) der Einkapselung (16) aufweist, und
einen kegelstumpfförmigen Abschnitt (182B), der sich durch den zweiten Abschnitt (162) der Einkapselung (16; 161, 162) erstreckt, wobei der kegelstumpfförmige Abschnitt (182B) ein erstes Ende mit einem ersten Durchmesser an der Zwischenebene (1612) der Einkapselung (16; 161, 162) und ein zweites Ende mit einem zweiten Durchmesser entfernt von der Zwischenebene (1612) der Einkapselung (16; 161, 162) aufweist, wobei der zweite Durchmesser des kegelstumpfförmigen Abschnitts (182B) kleiner ist als der erste Durchmesser des kegelstumpfförmigen Abschnitts (182B),
**dadurch gekennzeichnet, dass** das erste Ende des kegelstumpfförmigen Abschnitts (182B) eine Fläche aufweist, die kleiner ist als die Querschnittsfläche des vergrößerten Kragenabschnitts (182A) an der Zwischenebene (1612) der Einkapselung (16).

10. Vorrichtung (10) nach Anspruch 9, wobei der kegelstumpfförmige Abschnitt (182B) der mindestens einen elektrisch leitfähigen Durchkontaktierung (182) ein Seitenverhältnis von etwa gleich 1:1 aufweist.

11. Vorrichtung (10) nach Anspruch 9 oder Anspruch 10, wobei der mindestens eine Halbleiterchip (14) eine dem Substrat (12A, 12B) gegenüberliegende Vorderfläche aufweist, wobei die Vorderfläche des mindestens einen Halbleiterchips (14) mindestens etwa auf der Zwischenebene (1612) der Einkapselung (16; 161, 162) aus LDS-Material (16; 161, 162) liegt, die auf den mindestens einen auf dem Substrat (12A, 12B) angeordneten Halbleiterchip (14) geformt ist.

12. Vorrichtung (10) nach einem der Ansprüche 9 bis 11, wobei der mindestens eine Halbleiterchip (14) an einer Chipkontaktstelle (12A) eines Leiterrahmens angeordnet ist, der ein Array elektrisch leitfähiger Leitungen (12B) um die Chipkontaktstelle (12A) herum umfasst, wobei die mindestens eine elektrisch leitfähige Durchkontaktierung (182) sich durch den ersten (161) und den zweiten (162) Abschnitt der Einkapselung (16; 161, 162) aus LDS-Material von der Außenfläche (1613) der Einkapselung (16; 162, 162) zu mindestens einer Leitung in dem Array elektrisch leitfähiger Leitungen (12B) um die Chipkontaktstelle (12A) herum erstreckt.

13. Vorrichtung (10) nach Anspruch 11 und 12, die Folgendes umfasst:
mindestens einer kegelstumpfförmigen, elektrisch leitfähigen Durchkontaktierung (181), die sich durch den ersten Abschnitt (161) der Einkapselung (16; 161, 162) aus LDS-Material von der Außenfläche (1613) der Einkapselung (16; 161, 162) zu einer Vorderfläche des mindestens einen Halbleiterchips (14) erstreckt, und
mindestens eine lineare, elektrisch leitfähige Formation (183), die sich an der Außenfläche (1613) der Einkapselung (16; 161, 162) aus LDS-Material erstreckt und die mindestens eine kegelstumpfförmige, elektrisch leitfähige Durchkontaktierung (181) und den vergrößerten Kragenabschnitt (182A) der mindestens einen elektrisch leitfähigen Durchkontaktierung (182) koppelt, um die elektrische Kopplung des mindestens einen Halbleiterchips (14) mit der mindestens einen Leitung in dem Array elektrisch leitfähiger Leitungen (12B) um die Chipkontaktstelle (12A) herum bereitzustellen.

14. Vorrichtung (10) nach einem der Ansprüche 9 bis 13, die Folgendes umfasst:
mindestens eine laserabgetragene, ausgewählte Stelle (181', 182A', 182B'; 183') der Einkapselung (16; 161, 162) aus LDS-Material, und
Metallmaterial, vorzugsweise Kupfer, das auf die mindestens eine laserabgetragene, ausgewählte Stelle (181', 182A', 182B'; 183') der Einkapselung (16; 161, 162) aus LDS-Material aufgewachsen ist.

15. Vorrichtung (10) nach Anspruch 14, wobei das Metallmaterial, das auf die mindestens eine laserabgetragene, ausgewählte Stelle (181', 182A', 182B'; 183') der Einkapselung (16; 161, 162) aus LDS-Material aufgewachsen ist, Folgendes umfasst:
Metallmaterial, das stromlos auf die mindestens eine laserabgetragene, ausgewählte Stelle (181', 182A', 182B'; 183') der Einkapselung (16; 161, 162) aufgewachsen ist, und
Metallmaterial, das elektrolytisch auf das Metallmaterial aufwächst, das stromlos auf die mindestens eine laserabgetragene, ausgewählte Stelle (181', 182A', 182B'; 183') der Einkapselung (16; 161, 162) aufgewachsen ist.

## Revendications

1. Procédé comprenant les étapes suivantes :
disposer sur un substrat (12A, 12B) au moins une matrice de semiconducteur (14),
mouler une encapsulation de matériau de structuration directe au laser, ou LDS, (16 ; 161, 162) sur ladite au moins une matrice de semiconducteur (14) disposée sur le substrat (12A, 12B), l'encapsulation (16) ayant une surface extérieure (1613) à l'opposé du substrat (12A, 12B) et comprenant une première partie (161) de l'encapsulation (16) entre la surface extérieure (1613) et un plan intermédiaire (1612) de l'encapsulation (16) ainsi qu'une deuxième partie (162) de l'encapsulation (16) adjacente au substrat (12A, 12B) et s'arrêtant à la première partie (161) de l'encapsulation (16) au niveau dudit plan intermédiaire (1612), et
fournir au moins un trou d'interconnexion électriquement conducteur (182) traversant l'encapsulation de matériau LDS (16 ; 161, 162), dans lequel ledit au moins un trou d'interconnexion électriquement conducteur (182) comprend :
une section de col élargie (182A) traversant la première partie (161) de l'encapsulation (16) de la surface extérieure (1613) au plan intermédiaire (1612) de l'encapsulation (16), la section de col élargie (182A) ayant une section transversale au niveau du plan intermédiaire (1612) de l'encapsulation (16), et
une section tronconique (182B) traversant la deuxième partie (162) de l'encapsulation (16 ; 161, 162), d'une première extrémité ayant un premier diamètre au plan intermédiaire (1612) de l'encapsulation (16 ; 161, 162) à une deuxième extrémité ayant un deuxième diamètre à l'écart du plan intermédiaire (1612) de l'encapsulation (16 ; 161, 162), le deuxième diamètre de la section tronconique (182B) étant plus petit que le premier diamètre de la section tronconique (182B),
**caractérisé en ce que** la première extrémité de la section tronconique (182B) a une aire plus petite que la section transversale de la section de col élargie (182A) au niveau du plan intermédiaire (1612) de l'encapsulation (16).

2. Procédé selon la revendication 1, comprenant la fourniture dudit au moins un trou d'interconnexion électriquement conducteur (182) traversant l'encapsulation de matériau LDS (16 ; 161, 162), en formant la section de col élargie (182A) puis en formant la section tronconique (182B) de façon consécutive.

3. Procédé selon la revendication 1 ou 2, dans lequel la section tronconique (182B) dudit au moins un trou d'interconnexion électriquement conducteur (182) a un rapport d'aspect à peu près égal à 1/1.

4. Procédé selon l'une quelconque des revendications 1 à 3, comprenant le fait de disposer sur le substrat (12A, 12B) au moins une matrice de semiconducteur (14) ayant une surface avant à l'opposé du substrat (12A, 12B), dans lequel la surface avant de ladite au moins une matrice de semiconducteur (14) se trouve au moins approximativement au niveau du plan intermédiaire (1612) de l'encapsulation (16 ; 161, 162) de matériau LDS (16 ; 161, 162) moulée sur ladite au moins une matrice de semiconducteur (14) disposée sur le substrat (12A, 12B).

5. Procédé selon l'une quelconque des revendications précédentes, dans lequel ladite au moins une matrice de semiconducteur (14) est disposée au niveau d'une plage de matrice (12A) d'une grille de connexion comprenant un groupe de conducteurs électriques (12B) autour de la plage de matrice (12A), dans lequel le procédé comprend la fourniture dudit au moins un trou d'interconnexion électriquement conducteur (182) traversant la première (161) et la deuxième (162) parties de l'encapsulation (16 ; 161, 162) de matériau LDS, de la surface extérieure (1613) de l'encapsulation (16 ; 161, 162) à au moins un conducteur du groupe de conducteurs électriques (12B) autour de la plage de matrice (12A).

6. Procédé selon les revendications 4 et 5, dans lequel le procédé comprend le fait de former :
au moins un trou d'interconnexion tronconique électriquement conducteur (181) traversant la première partie (161) de l'encapsulation (16 ; 161, 162) de matériau LDS, de la surface extérieure (1613) de l'encapsulation (16 ; 161, 162) à une surface avant de ladite au moins une matrice de semiconducteur (14), et
au moins une formation électriquement conductrice linéaire (183) s'étendant sur la surface extérieure (1613) de l'encapsulation (16 ; 161, 162) de matériau LDS et couplant ledit au moins un trou d'interconnexion tronconique électriquement conducteur (181) et la section de col élargie (182A) dudit au moins un trou d'interconnexion électriquement conducteur (182) pour fournir un couplage électrique de ladite au moins une matrice de semiconducteur (14) avec ledit au moins un conducteur dans le groupe de conducteurs électriques (12B) autour de la plage de matrice (12A).

7. Procédé selon l'une quelconque des revendications précédentes, comprenant les étapes suivantes :
appliquer une énergie de faisceau laser (LB) à au moins un emplacement choisi (181', 182A', 182B' ; 183') de l'encapsulation (16 ; 161, 162) de matériau LDS, et
faire croître (P) un matériau métallique, de préférence du cuivre, sur ledit au moins un emplacement choisi (181', 182A', 182B' ; 183') de l'encapsulation (16 ; 161, 162) de matériau LDS auquel une énergie de faisceau laser (LB) a été appliquée.

8. Procédé selon la revendication 7, dans lequel ladite croissance d'un matériau métallique (P) comprend les étapes suivantes :
faire croître de façon autocatalytique un matériau métallique sur ledit au moins un emplacement choisi (181', 182A', 182B' ; 183') de l'encapsulation (16 ; 161, 162) de matériau LDS auquel une énergie de faisceau laser (LB) a été appliquée, et
faire croître de façon électrolytique un matériau métallique sur le matériau métallique déposé de façon autocatalytique sur ledit au moins un emplacement choisi (181', 182A', 182B' ; 183') auquel une énergie de faisceau laser (LB) a été appliquée.

9. Dispositif (10) comprenant :
au moins une matrice de semiconducteur (14) disposée sur un substrat (12A, 12B),
une encapsulation de matériau de structuration directe au laser, ou LDS, (16 ; 161, 162) moulée sur ladite au moins une matrice de semiconducteur (14) disposée sur le substrat (12A, 12B), l'encapsulation (16) ayant une surface extérieure (1613) à l'opposé du substrat (12A, 12B) et comprenant une première partie (161) de l'encapsulation (16) entre la surface extérieure (1613) et un plan intermédiaire (1612) de l'encapsulation (16) ainsi qu'une deuxième partie (162) de l'encapsulation (16) adjacente au substrat (12A, 12B) et s'arrêtant à la première partie (161) de l'encapsulation (16) au niveau dudit plan intermédiaire (1612), et
au moins un trou d'interconnexion électriquement conducteur (182) traversant l'encapsulation de matériau LDS (16 ; 161, 162), dans lequel ledit au moins un trou d'interconnexion électriquement conducteur (182) comprend :
une section de col élargie (182A) traversant la première partie (161) de l'encapsulation (16) de la surface extérieure (1613) au plan intermédiaire (1612) de l'encapsulation (16), la section de col élargie (182A) ayant une section transversale au niveau du plan intermédiaire (1612) de l'encapsulation (16), et
une section tronconique (182B) traversant la deuxième partie (162) de l'encapsulation (16 ; 161, 162), dans laquelle la section tronconique (182B) a une première extrémité ayant un premier diamètre au plan intermédiaire (1612) de l'encapsulation (16 ; 161, 162) et une deuxième extrémité ayant un deuxième diamètre à l'écart du plan intermédiaire (1612) de l'encapsulation (16 ; 161, 162), dans laquelle le deuxième diamètre de la section tronconique (182B) est plus petit que le premier diamètre de la section tronconique (182B),
**caractérisé en ce que** la première extrémité de la section tronconique (182B) a une aire plus petite que la section transversale de la section de col élargie (182A) au niveau du plan intermédiaire (1612) de l'encapsulation (16).

10. Dispositif (10) selon la revendication 9, dans lequel la section tronconique (182B) dudit au moins un trou d'interconnexion électriquement conducteur (182) a un rapport d'aspect à peu près égal à 1/1.

11. Dispositif (10) selon la revendication 9 ou 10, dans lequel ladite au moins une matrice de semiconducteur (14) a une surface avant à l'opposé du substrat (12A, 12B), dans lequel la surface avant de ladite au moins une matrice de semiconducteur (14) se trouve au moins approximativement au niveau du plan intermédiaire (1612) de l'encapsulation (16 ; 161, 162) de matériau LDS (16 ; 161, 162) moulée sur ladite au moins une matrice de semiconducteur (14) disposée sur le substrat (12A, 12B).

12. Dispositif (10) selon l'une quelconque des revendications 9 à 11, dans lequel ladite au moins une matrice de semiconducteur (14) est disposée au niveau d'une plage de matrice (12A) d'une grille de connexion comprenant un groupe de conducteurs électriques (12B) autour de la plage de matrice (12A), dans lequel ledit au moins un trou d'interconnexion électriquement conducteur (182) traverse la première (161) et la deuxième (162) parties de l'encapsulation (16 ; 161, 162) de matériau LDS, de la surface extérieure (1613) de l'encapsulation (16 ; 161, 162) à au moins un conducteur du groupe de conducteurs électriques (12B) autour de la plage de matrice (12A).

13. Dispositif (10) selon les revendications 11 et 12, comprenant :
au moins un trou d'interconnexion tronconique électriquement conducteur (181) traversant la première partie (161) de l'encapsulation (16 ; 161, 162) de matériau LDS, de la surface extérieure (1613) de l'encapsulation (16 ; 161, 162) à une surface avant de ladite au moins une matrice de semiconducteur (14), et
au moins une formation électriquement conductrice linéaire (183) s'étendant sur la surface extérieure (1613) de l'encapsulation (16 ; 161, 162) de matériau LDS et couplant ledit au moins un trou d'interconnexion tronconique électriquement conducteur (181) et la section de col élargie (182A) dudit au moins un trou d'interconnexion électriquement conducteur (182) pour fournir un couplage électrique de ladite au moins une matrice de semiconducteur (14) avec ledit au moins un conducteur dans le groupe de conducteurs électriques (12B) autour de la plage de matrice (12A).

14. Dispositif (10) selon l'une quelconque des revendications 9 à 13, comprenant :
au moins un emplacement choisi ayant subi une ablation laser (181', 182A', 182B' ; 183') de l'encapsulation (16 ; 161, 162) de matériau LDS, et
un matériau métallique, de préférence du cuivre, que l'on a fait croître sur ledit au moins un emplacement choisi ayant subi une ablation laser (181', 182A', 182B' ; 183') de l'encapsulation (16 ; 161, 162) de matériau LDS.

15. Dispositif (10) selon la revendication 14, dans lequel le matériau métallique que l'on a fait croître sur ledit au moins un emplacement choisi ayant subi une ablation laser (181', 182A', 182B' ; 183') de l'encapsulation (16 ; 161, 162) de matériau LDS comprend :
un matériau métallique que l'on a fait croître de façon autocatalytique sur ledit au moins un emplacement choisi ayant subi une ablation laser (181', 182A', 182B' ; 183') de l'encapsulation (16 ; 161, 162), et
un matériau métallique que l'on fait croître de façon électrolytique sur le matériau métallique que l'on a fait croître de façon autocatalytique sur ledit au moins un emplacement choisi ayant subi une ablation laser (181', 182A', 182B' ; 183') de l'encapsulation (16 ; 161, 162).
